# EUROPEAN PATENT APPLICATION

(11) **EP 4 716 420 A1**
(43) Date of publication of application: **25.03.2026**
(21) Application number: 25173644.3
(22) Date of filing: 30.04.2025
(51) Int. Cl.: H10F 77/20, H10F 19/75, H10F 10/165

(54) **IBC SOLAR CELL AND PREPARATION METHOD THEREOF, PHOTOVOLTAIC MODULE, AND POWER GENERATION DEVICE**

(30) Priority: 24.09.2024 CN 202411341428
(71) Applicant: Tongwei Solar (Chengdu) Co., Ltd., Chengdu, Sichuan 610299 (CN)
(72) Inventor: PAN, Shunmin, Chengdu, 610299 (CN); DENG, Mingzhang, Chengdu, 610299 (CN); MENG, Xiajie, Chengdu, 610299 (CN)
(74) Representative: Michalski Hüttermann & Partner Patentanwälte mbB

(57) **Abstract**

An IBC solar cell includes a silicon substrate, a first doped layer, a second doped layer, and a leakage conductive structure, wherein the first doped layer and the second doped layer are spaced apart on a backside of the silicon substrate, doping types of the first doped layer and the second doped layer are different, an isolation region is provided between the first doped layer and the second doped layer; the leakage conductive structure includes a first conductive block, a second conductive block, and a leakage tunneling layer, the first conductive block is connected to the first doped layer, and the second conductive block is connected to the second doped layer, the first conductive block and the second conductive block are at least partially overlapped, and the leakage tunneling layer is provided between the first conductive block and the second conductive block.

## Description

### TECHNICAL FIELD

The present disclosure relates to the technical field of solar cells, particularly to an IBC solar cell and a preparation method thereof, a photovoltaic module, and a power generation device.

### BACKGROUND

IBC (Interdigitated Back Contact) photovoltaic modules are suitable as residential photovoltaic modules because of their beautiful appearance and high power density. However, they are easily to be shaded by nearby trees or bird droppings. Alternatively, when IBC photovoltaic modules are installed in non-residential scenarios, the presence of external shading factors can easily lead to hot spot effect in the IBC photovoltaic modules. How to reduce the influence of the hot spot effect of IBC photovoltaic modules on the output power of the modules is a technical issue that needs to be addressed urgently by those skilled in the art.

### SUMMARY

Accordingly, it is necessary to provide an IBC solar cell, which can reduce hot spot effect of an IBC photovoltaic module.

According to a first aspect, an IBC solar cell is provided, including:
a silicon substrate;
a first doped layer and a second doped layer spaced apart on a backside of the silicon substrate, wherein doping types of the first doped layer and the second doped layer are different, and an isolation region is provided between the first doped layer and the second doped layer; and
a leakage conductive structure provided between the first doped layer and the second doped layer, wherein the leakage conductive structure includes a first conductive block, a second conductive block, and a leakage tunneling layer, the first conductive block is connected to the first doped layer, and the second conductive block is connected to the second doped layer, the first conductive block and the second conductive block are at least partially overlapped, and the leakage tunneling layer is provided between the first conductive block and the second conductive block.

In one of the embodiments, a material of the first conductive block is a same as or different from a material of the first doped layer.

In one of the embodiments, a material of the second conductive block is a same as or different from a material of the second doped layer.

In one of the embodiments, the first conductive block includes doped silicon with a same doping type as a doping type of the first doped layer.

In one of the embodiments, the second conductive block includes doped silicon with a same doping type as a doping type of the second doped layer.

In one of the embodiments, the first conductive block is integrally formed with the first doped layer.

In one of the embodiments, the second conductive block is integrally formed with the second doped layer.

In one of the embodiments, the leakage tunneling layer is a silicon oxide layer or a hydrogenated amorphous silicon layer.

In one of the embodiments, a thickness of the leakage tunneling layer is in a range from 1 nm to 5 nm.

In one of the embodiments, a width of the first conductive block is in a range from 5 µm to 500 µm.

In one of the embodiments, a width of the second conductive block is in a range from 5 µm to 500 µm.

In one of the embodiments, a width of an overlapped portion between the first conductive block and the second conductive block is in a range from 1 µm to 300 µm.

In one of the embodiments, along a thickness direction of the silicon substrate, an orthographic projection of the first conductive block is within an orthographic projection of the second conductive block, or an orthographic projection of the first conductive block is partially overlapped with an orthographic projection of the second conductive block.

In one of the embodiments, an edge of the first doped layer is inwardly recessed to form a recessed portion, and the first conductive block is located within the recessed portion.

In one of the embodiments, the first conductive block protrudes from the edge of the first doped layer towards the second doped layer.

In one of the embodiments, the leakage conductive structure further includes an insulating layer provided between overlapped portions of the first conductive block and the second conductive block.

In one of the embodiments, the insulating layer includes a phosphosilicate glass layer, a borosilicate glass layer, a silicon nitride layer, a silicon oxide layer, or any combination thereof.

In one of the embodiments, a thickness of the insulating layer is in a range from 1 nm to 90 nm.

In one of the embodiments, a part of the leakage tunneling layer is provided between the insulating layer and the second conductive block.

In one of the embodiments, the first doped layer includes a first busbar region and a plurality of first finger regions connected to the first busbar region, the second doped layer includes a second busbar region and a plurality of second finger regions connected to the second busbar region, and the first finger regions and the second finger regions located between adjacent first busbar region and second busbar region are alternately spaced apart.

In one of the embodiments, a plurality of leakage conductive structures are provided, and at least part of the leakage conductive structures are connected to the first finger region and the second finger region that are adjacent to each other.

In one of the embodiments, a plurality of leakage conductive structures are provided, and at least part of the leakage conductive structures are connected to the first finger region and the second busbar region.

In one of the embodiments, a plurality of leakage conductive structures are provided, and at least part of leakage conductive structures are connected to the second finger region and the first busbar region.

In one of the embodiments, a plurality of leakage conductive structures are provided, a plurality of first soldering pad regions are provided on the first busbar region, and at least part of the leakage conductive structures are connected to the second finger region and the plurality of first soldering pad regions.

In one of the embodiments, a plurality of leakage conductive structures are provided, a plurality of second soldering pad regions are provided on the second busbar region, and at least part of the leakage conductive structures are connected to the first finger region and the plurality of second soldering pad regions.

In one of the embodiments, the IBC solar cell further includes a first passivation tunneling layer and a second passivation tunneling layer; the first passivation tunneling layer is provided between the first doped layer and the silicon substrate, and between the first conductive block and the silicon substrate; the second passivation tunneling layer is provided between the second doped layer and the silicon substrate.

In one of the embodiments, the second passivation tunneling layer is integrally formed with the leakage tunneling layer.

In one of the embodiments, the first passivation tunneling layer abuts against the leakage tunneling layer.

In one of the embodiments, a passivating layer and a protective layer are sequentially stacked on the sides of the first doped layer, the second doped layer, the isolation region, and the leakage conductive structure away from the silicon substrate.

According to a second aspect, a method for preparing an IBC solar cell includes:
providing a silicon substrate; and
forming a first doped layer, a first conductive block, a second doped layer, a second conductive block, and a leakage tunneling layer on a backside of the silicon substrate, respectively;
wherein the first doped layer and the second doped layer are spaced apart to form an isolation region, the first conductive block is located in the isolation region and connected to the first doped layer, the second conductive block is located in the isolation region and connected to the second doped layer, the first conductive block and the second conductive block are partially overlapped, the leakage tunneling layer is provided between the first conductive block and the second conductive block, and the first conductive block, the second conductive block, and the leakage tunneling layer constitute a leakage conductive structure.

In one of the embodiments, forming a first doped layer and a first conductive block on the backside of the silicon substrate includes:
sequentially depositing a first tunneling oxide layer, a first doped silicon layer, and a first mask layer on the backside of the silicon substrate, and
removing portions of the mask layer, the first doped silicon layer, and the first tunneling oxide layer outside the regions of the first doped layer and the first conductive block on the backside of the silicon substrate to obtain a cell intermediate.

In one of the embodiments, forming the second doped layer, the second conductive block, and the leakage tunneling layer on the backside of the silicon substrate includes:
depositing a second tunneling oxide layer and a second doped silicon layer on the backside of the silicon substrate after forming a first doped layer and a first conductive block; and
removing portions of the second doped silicon layer and the second tunneling oxide layer outside the regions of the second doped layer and the second conductive block on the backside of the silicon substrate.

In one of the embodiments, removing portions of the mask layer, the first doped silicon layer, and the first tunneling oxide layer outside the regions of the first doped layer and the first conductive block on the backside of the silicon substrate includes:
etching the mask layer outside the regions of the first doped layer and the first conductive block on the backside of the silicon substrate 11 with a laser; and
etching away the first doped silicon layer and the first tunneling oxide layer outside the regions of the first doped layer and the first conductive block on the backside of the silicon substrate by using an alkaline solution.

In one of the embodiments, removing portions of the second doped silicon layer and the second tunneling oxide layer outside the regions of the second doped layer and the second conductive block on the backside of the silicon substrate includes:
etching away the second doped silicon layer and the second tunneling oxide layer outside the regions of the second doped layer and the second conductive block on the backside of the silicon substrate by using an alkaline solution.

In one of the embodiments, removing portions of the second doped silicon layer and the second tunneling oxide layer outside the regions of the second doped layer and the second conductive block on the backside of the silicon substrate further includes: removing a portion of the mask layer outside the regions of the second doped layer and the second conductive block on the backside of the silicon substrate, wherein a retained mask layer serves as an insulating layer.

In one of the embodiments, after removing the second doped silicon layer and the second tunneling oxide layer outside the regions of the second doped layer and the second conductive block on the backside of the silicon substrate, the method further includes: forming a passivating layer and a protective layer sequentially on the backside of the silicon substrate.

According to a third aspect of the present application, an IBC photovoltaic module is provided, including a plurality of the IBC solar cells according to the first aspect of the present application, wherein the plurality of IBC solar cells are interconnected to form an IBC solar cell string.

According to a fourth aspect of the present application, a power generation device is provided, including the IBC solar cell according to any the first aspect of the present application, or the IBC photovoltaic module according to the third aspect of the present application.

The leakage conductive structure is provided in the isolation region, and the leakage conductive structure includes the first conductive block, the second conductive block, and the leakage tunneling layer. The first conductive block is connected to the first doped layer, and the second conductive block is connected to the second doped layer. The first conductive block and the second conductive block are at least partially overlapped, and the leakage tunneling layer is provided between the first conductive block and the second conductive block. Under normal operating conditions of the cell, the first conductive block is separated from the second conductive block by the leakage tunneling layer in the leakage conductive structure. However, when there is a certain reverse bias voltage in the cell, carriers can pass through the leakage tunneling layer, establishing conduction between the first conductive block and the second conductive block, and the leakage conductive structure forms a leakage current path, helping to alleviate or prevent the concentration of the leakage current in some local regions of the cell, thereby reducing the impact of the hot spot effect.

Additionally, by configuring the first conductive block and the second conductive block to be at least partially overlapped, i.e., the first conductive block is at least partially overlapped on the second conductive block, or the second conductive block is at least partially overlapped on the first conductive block, the leakage conductive structure imposes relatively low precision requirements on the preparation process, and thus is less susceptible to variations in manufacturing accuracy and process fluctuations, making it easier to achieve in production and more feasible for manufacturing.

### BRIEF DESCRIPTION OF THE DRAWINGS

FIG. 1 is a schematic view of an IBC solar cell according to an embodiment of the present application.
FIG. 2 is a schematic view of a backside of an IBC solar cell according to an embodiment of the present application.
FIG. 3 is a schematic view of a leakage conductive structure of an IBC solar cell according to an embodiment of the present application.
FIG. 4 is a schematic view of another leakage conductive structure of an IBC solar cell according to another embodiment of the present application.
FIG. 5 is a schematic view of a first doped layer of an IBC solar cell according to an embodiment of the present application.
FIG. 6 is a schematic view of connection a first conductive block to a first doped layer in an IBC solar cell according to an embodiment of the present application.
FIG. 7 is a schematic view of connection a first conductive block to a first doped layer in another IBC solar cell according to another embodiment of the present application.
FIG. 8 is a schematic view of connection of a leakage conductive structure in an IBC solar cell according to an embodiment of the present application.
FIG. 9 is a schematic view of a doped layer on a backside of an IBC solar cell according to an embodiment of the present application.
FIG. 10 is a schematic view of a doped layer on a backside of another IBC solar cell according to an embodiment of the present application.
FIG. 11 is a schematic view of a doped layer on a backside of yet another IBC solar cell according to an embodiment of the present application.
FIG. 12 is a schematic view of a doped layer on a backside of still another IBC solar cell according to an embodiment of the present application.
FIG. 13 is a schematic view of connection of another leakage conductive structure in an IBC solar cell according to another embodiment of the present application.
FIG. 14 is a schematic view of connection of yet another leakage conductive structure in an IBC solar cell according to yet another embodiment of the present application.
FIG. 15 is a schematic view of connection of still another leakage conductive structure in an IBC solar cell according to still another embodiment of the present application.
FIG. 16 is a schematic view of connection of still another leakage conductive structure in an IBC solar cell according to still another embodiment of the present application.
FIG. 17 is a schematic view of electrode gridlines and leakage conductive structures on a backside of an IBC solar cell according to an embodiment of the present application.
FIG. 18 is a schematic view of electrode gridlines and leakage conductive structures on a backside of a busbar-free IBC solar cell according to an embodiment of the present application.
FIG. 19 is a schematic view after depositing a first tunneling oxide layer, a first doped silicon layer, and a mask layer on a backside of a silicon substrate in a preparation method according to an embodiment of the present application.
FIG. 20 is a schematic view of a cell intermediate prepared by a method according to an embodiment of the present application.
FIG. 21 is a schematic view after depositing a second tunneling oxide layer, a second doped silicon layer, and a second mask layer on a cell intermediate.
FIG. 22 is a schematic view after removing portions of the second mask layer, the second doped silicon layer, the second tunneling oxide layer, and the first mask layer outside the regions of the second doped layer and the second conductive block on the backside of the silicon substrate, and removing the remaining second mask layer, in a preparation method according to an embodiment of the present application.
FIG. 23 is a schematic view of an IBC solar cell prepared by a method according to an embodiment of the present application.

### DETAILED DESCRIPTION

The embodiments of the present application will be described in detail in order to make the objects, features, and advantages of the present application more apparent and understandable. Many specific details are disclosed in the following description to facilitate a comprehensive understanding of the present application. However, it should be noted that the present application can be implemented in various ways different from those described herein, and those skilled in the art may make similar improvements without departing from the scope of the present application. Therefore, the present application is not limited to the specific embodiments disclosed below.

In addition, the terms "first" and "second" are used for descriptive purposes only, and cannot be construed as indicating or implying a relative importance, or implicitly specifying the number of the indicated technical features. Thus, the quantity of the feature defined with "first" or "second" may explicitly or implicitly be at least one. In the description of the present application, "a plurality of" means at least two, such as two, three, unless otherwise defined explicitly and specifically.

Unless defined otherwise, all technical and scientific terms used herein have the same meaning as commonly understood by those skilled in the art of the present application. The terms used in the specification of the present application are for the purpose of describing exemplary examples only and are not intended to limit the present application. The term "and/or" used herein includes any and all combinations of one or more of the associated listed items.

As discussed in the background, conventional IBC solar cells are easily to be shaded by nearby trees or bird droppings, so that the IBC photovoltaic modules are prone to hot spot effect, thereby resulting in a decrease in the output power of the modules. Therefore, how to reduce the influence of the hot spot effect of IBC photovoltaic modules on the output power of the modules is a technical issue that needs to be addressed urgently by those skilled in the art. By modifying the structure of the IBC solar cell, the present application effectively reduces the probability of the hot spot phenomenon in IBC solar cell and its photovoltaic modules.

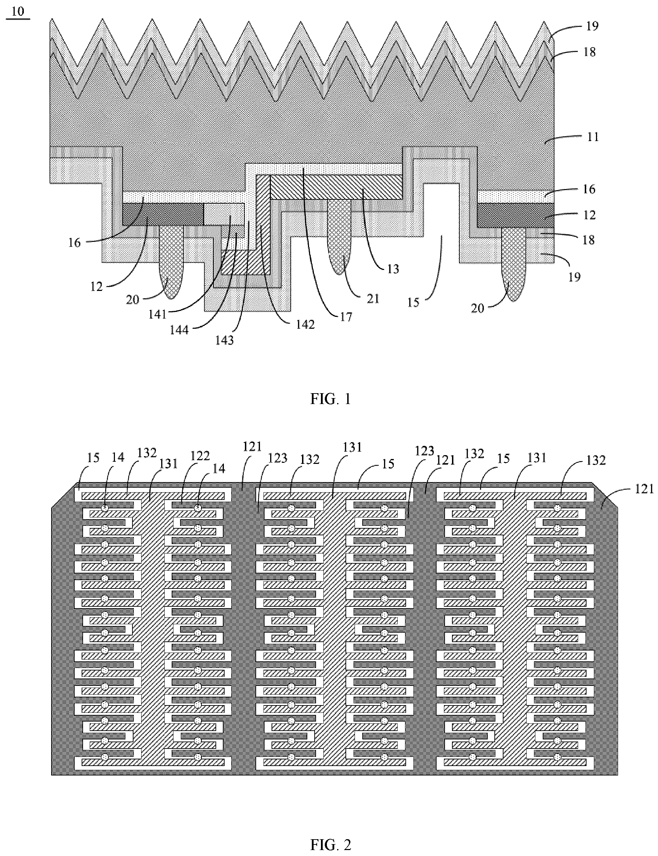

Referring to FIGS. 1 to 3, an embodiment of the present application provides an IBC solar cell 10. The IBC solar cell 10 includes a silicon substrate 11, a first doped layer 12, a second doped layer 13, a leakage conductive structure 14, and an isolation region 15. The first doped layer 12 and the second doped layer 13 are spaced apart and provided on a backside of the silicon substrate 11, and doping types of the first doped layer 12 and the second doped layer 13 are different. The isolation region 15 is provided between the first doped layer 12 and the second doped layer 13. The leakage conductive structure 14 is provided between the first doped layer 12 and the second doped layer 13. The leakage conductive structure 14 includes a first conductive block 141, a second conductive block 142, and a leakage tunneling layer 143. The first conductive block 141 is connected to the first doped layer 12, and the second conductive block 142 is connected to the second doped layer 13. The first conductive block 141 and the second conductive block 142 are at least partially overlapped, and the leakage tunneling layer 143 is provided between the first conductive block 141 and the second conductive block 142.

In the conventional IBC solar cell, the first doped layer and the second doped layer are separated by the isolation region. However, during actual manufacturing, issues or defects such as scratches, over-etching, cracks, pinholes, paste leakage, PN-region bridging, or edge leakage may occur in the cell. In such cases, when partial shading leading to the hot-spot effect in the IBC photovoltaic module occurs, under high reverse bias voltage, leakage currents pass through these defect points causing the cell to form a large current path locally and generate excessive temperature, resulting in the occurrence of the hot spot phenomenon in the cell.

In the above IBC solar cell 10 of the one embodiment, the leakage conductive structure 14 is provided in the isolation region 15, and the leakage conductive structure 14 includes the first conductive block 141, the second conductive block 142, and the leakage tunneling layer 143. The first conductive block 141 is connected to the first doped layer 12, and the second conductive block 142 is connected to the second doped layer 13. The first conductive block 141 and the second conductive block 142 are at least partially overlapped, and the leakage tunneling layer 143 is provided between the first conductive block 141 and the second conductive block 142. Under normal operating conditions of the cell, i.e., when the IBC photovoltaic assembly is not shaded by trees or bird droppings to generate the hot-spot effect, the first conductive block 141 is separated from the second conductive block 142 by the leakage tunneling layer 143 in the leakage conductive structure 14. However, when the IBC photovoltaic module experiences the hot-spot effect and there is a certain reverse bias voltage in the IBC solar cell, photogenerated carriers can pass through the leakage tunneling layer 143, enabling conduction between the first conductive block 141 and the second conductive block 142. In this case the leakage conductive structure 14 forms a leakage current path, which can alleviate or prevent the concentration of the leakage current in some local regions of the cell, thereby reducing the impact of the hot spot effect.

Additionally, by configuring the first conductive block 141 and the second conductive block 142 to be at least partially overlapped, i.e., the first conductive block 141 is at least partially overlapped on the second conductive block 142, or the second conductive block 142 is at least partially overlapped on the first conductive block 141, the leakage conductive structure 14 imposes relatively low precision requirements on the preparation process, and thus is less susceptible to variations in manufacturing accuracy and process fluctuations, making it easier to achieve in production and more feasible for manufacturing.

In some embodiments, the first conductive block 141 includes doped silicon with the same doping type as a doping type of the first doped layer 12, and the second conductive block 142 includes doped silicon with the same doping type as a doping type of the second doped layer 13. Thus, under a reverse bias voltage, carriers can pass through the leakage tunneling layer 143 to electrically connect the first doped layer 12 to the second doped layer 13, thus forming a leakage current path. It should be understood that, when the first doped layer 12 is an N-type doped layer, the first conductive block 141 is also an N-type doped conductive block, or when the first doped layer 12 is a P-type doped layer, the first conductive block 141 is also a P-type doped conductive block. Similarly, when the second doped layer 13 is an N-type doped layer, the second conductive block 142 is also an N-type doped conductive block, or when the second doped layer 13 is a P-type doped layer, the second conductive block 142 is also a P-type doped conductive block.

In some specific examples, both the first doped layer 12 and the first conductive block 141 are N-type doped silicon layers, while both the second doped layer 13 and the second conductive block 142 are P-type doped silicon layers. In some other examples, both the first doped layer 12 and the first conductive block 141 are P-type doped silicon layers, while both the second doped layer 13 and the second conductive block 142 are N-type doped silicon layers.

It should be noted that, a material of the first conductive block 141 can be the same as or different from a material of the first doped layer 12, as long as the first conductive block 141 can effectively transport carriers when there is a reverse bias voltage in the cell. Similarly, a material of the second conductive block 142 can be the same as or different from a material of the second doped layer 13, as long as the second conductive block 142 can effectively transport carriers when there is a reverse bias voltage in the cell.

In some specific examples, the materials of the first conductive block 141 and the second conductive block 142 are each independently selected from one or more of a doped silicon and an electrically conductive oxide. The doped silicon includes one or more of a boron-doped silicon, a phosphorus-doped silicon, a gallium-doped silicon, an arsenic-doped silicon, an antimony-doped silicon, or an aluminum-doped silicon. The conductive oxide includes one or more of indium tin oxide (ITO), fluorine-doped tin oxide (FTO), aluminum-doped zinc oxide (AZO), gallium oxide, or ruthenium oxide.

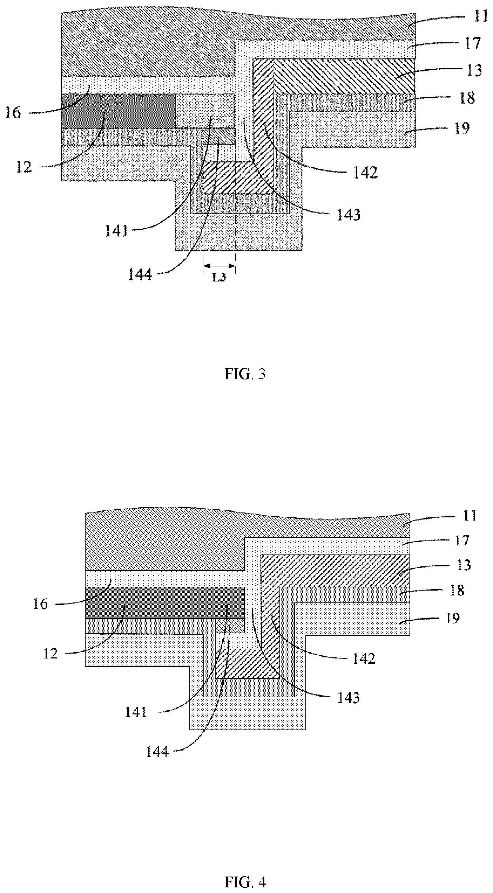

Referring to FIG. 4, in some embodiments, the first conductive block 141 is integrally formed with the first doped layer 12, and the second conductive block 142 is integrally formed with the second doped layer 13. That is, the first conductive block 141 and the first doped layer 12 can be simultaneously formed as an integrated structure during preparation; the second conductive block 142 and the second doped layer 13 can be simultaneously formed as an integrated structure during preparation. This facilitates simplifying the preparation process of the leakage conductive structure 14.

Referring to FIGS. 2 and 3, in some embodiments, the first conductive block 141 may not be integrally formed with the first doped layer 12, and the second conductive block 142 may not be integrally formed with the second doped layer 13. When adopting this structure, during preparation, the first conductive block 141 and the first doped layer 12 can be prepared separately, and the second conductive block 142 and the second doped layer 13 can be prepared separately.

In some embodiments, the leakage tunneling layer 143 is a silicon oxide layer or a hydrogenated amorphous silicon layer, with a thickness of 1 nm to 5 nm, optionally 1 nm to 3 nm. The first conductive block 141 and the second conductive block 142 can be spaced apart by providing an extremely thin leakage tunneling layer 143 therebetween, carriers can pass through the leakage tunneling layer 143 by tunneling effect in the presence of hot spot effect, enabling the carriers to flow between the first conductive block 141 and the second conductive block 142. Additionally, using a silicon oxide layer or hydrogenated amorphous silicon layer as the leakage tunneling layer 143 can passivate the dangling bonds on the surface of the silicon substrate 11, thereby providing excellent passivation effects.

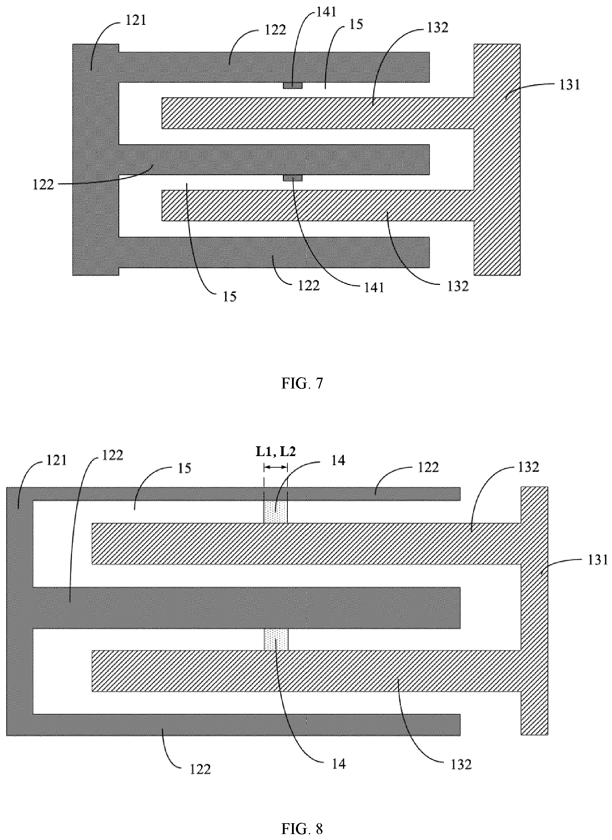

In some embodiments, a width of the first conductive block 141 (referring to L1 in FIG. 8) and a width of the second conductive block 142 (referring to L2 in FIG. 8) are each independently in a range from 5 µm to 500 µm. Controlling the widths of the first conductive block 141 and the second conductive block 142 within the range is more conducive to alleviating or preventing the concentration of leakage current in some local regions of the cell, thereby further reducing the impact of the hot spot effect. It should be understood that, the widths of the first conductive block 141 and the second conductive block 142 can each independently be 5 µm, 10 µm, 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, 200 µm, 220 µm, 250 µm, 280 µm, 300 µm, 320 µm, 350 µm, 380 µm, 400 µm, 420 µm, 450 µm, 480 µm, 500 µm, or any value within the range formed by any two of these values.

It should be noted that, the width of the first conductive block 141 refers to a maximum length between any two endpoints in a direction parallel to a longitudinal direction of the first doped layer 12. Similarly, the width of the second conductive block 142 refers to a maximum length between any two endpoints in a direction parallel to a longitudinal direction of the second doped layer 13.

In some embodiments, a width of an overlapped portion between the first conductive block 141 and the second conductive block 142 (referring to L3 in FIG. 3) is in a range from 1 µm to 300 µm. It should be understood that, the width of the overlapped portion can be 1 µm, 5 µm, 10 µm, 20 µm, 50 µm, 80 µm, 100 µm, 120 µm, 150 µm, 180 µm, 200 µm, 220 µm, 250 µm, 280 µm, 300 µm, or any value within the range formed by any two of these values.

It should be noted that, the width of the overlapped portion between the first conductive block 141 and the second conductive block 142 refers to a maximum length between any two endpoints of the overlapped portion in a direction parallel to a transverse direction of the first doped layer 12 or the second doped layer 13.

In some embodiments, along a thickness direction of the silicon substrate 11, an orthographic projection of the first conductive block 141 is within an orthographic projection of the second conductive block 142. That is, the first conductive block 141 is completely overlapped and covered by the second conductive block 142. In some other embodiments, in the thickness direction of the silicon substrate 11, the orthographic projection of the first conductive block 141 is partially overlapped with the orthographic projection of the second conductive block 142. That is, the second conductive block 142 only overlaps and covers a part of the first conductive block 141.

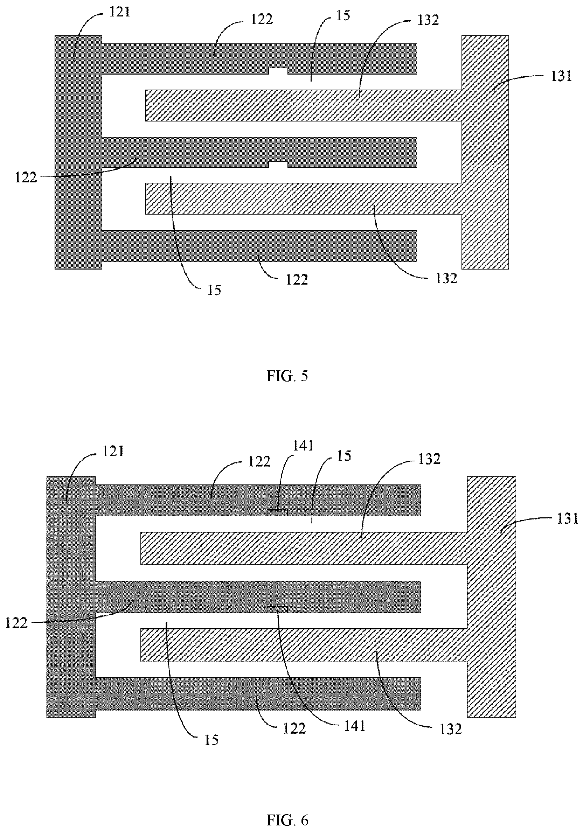

Referring to FIGS. 5 and 6, in some embodiments, an edge of the first doped layer 12 is recessed inwardly to form a recessed portion, and the first conductive block 141 is located in the recessed portion. That is, the first conductive block 141 is embedded in the recessed portion formed in the first doped layer 12. It should be understood that, in this structure, an outer sidewall of the first conductive block 141 may or may not be coplanar with an outer sidewall of the first doped layer 12 excluding the recessed portion.

Referring to FIG. 7, in some embodiments, the first conductive block 141 protrudes from the edge of the first doped layer 12 towards the second doped layer 142. That is, the edge of the first doped layer 12 is not provided with the recessed portion. The first conductive block 141 is connected to the outer sidewall of the first doped layer 12 and protrudes from the outer sidewall of the first doped layer 12 and extends towards the second doped layer 142.

Referring to FIG. 3, in some embodiments, the leakage conductive structure 14 further includes an insulating layer 144 provided between overlapped portions of the first conductive block 141 and the second conductive block 142. Specifically, the insulating layer 144 can be a phosphosilicate glass (PSG) layer, a borosilicate glass (BSG) layer, a silicon nitride layer, a silicon oxide layer, or any combination thereof. In some specific examples, a thickness of the insulating layer 144 can be in a range from 1 nm to 90 nm.

By providing the insulating layer 144 between the overlapped portions of the first conductive block 141 and the second conductive block 142, when the first conductive block 141 and the second conductive block 142 are doped silicon layers of different doping types, it is conductive to reducing or preventing the doping element in the second conductive block 142 from diffusing into the first conductive block 141 during the preparation of the second conductive block 142, thereby avoiding adverse effects on the carrier transport capability of the first conductive block 141.

In some embodiments, a part of the leakage tunneling layer 143 is provided between the insulating layer 144 and the second conductive block 142. That is, the first conductive block 141, the insulating layer 144, the leakage tunneling layer 143, and the second conductive block 142 are sequentially stacked in the leakage conductive structure 14. It should be understood that, the leakage tunneling layer 143 may or may not be provided between the insulating layer 144 and the second conductive block 142.

In some embodiments, the first doped layer 12 includes a first busbar region 121 and a plurality of first finger regions 122 connected to the first busbar region 121. The second doped layer 13 includes a second busbar region 131 and a plurality of second finger regions 132 connected to the second busbar region 131. Moreover, the first finger regions 122 and the second finger regions 132 located between adjacent first busbar region 121 and second busbar region 131 are alternately spaced apart, forming an interdigitated distribution structure.

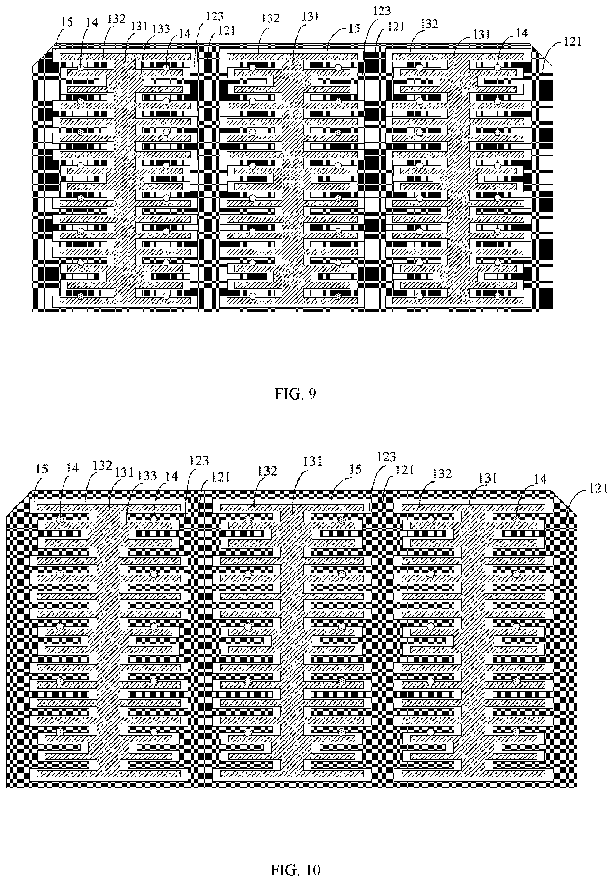

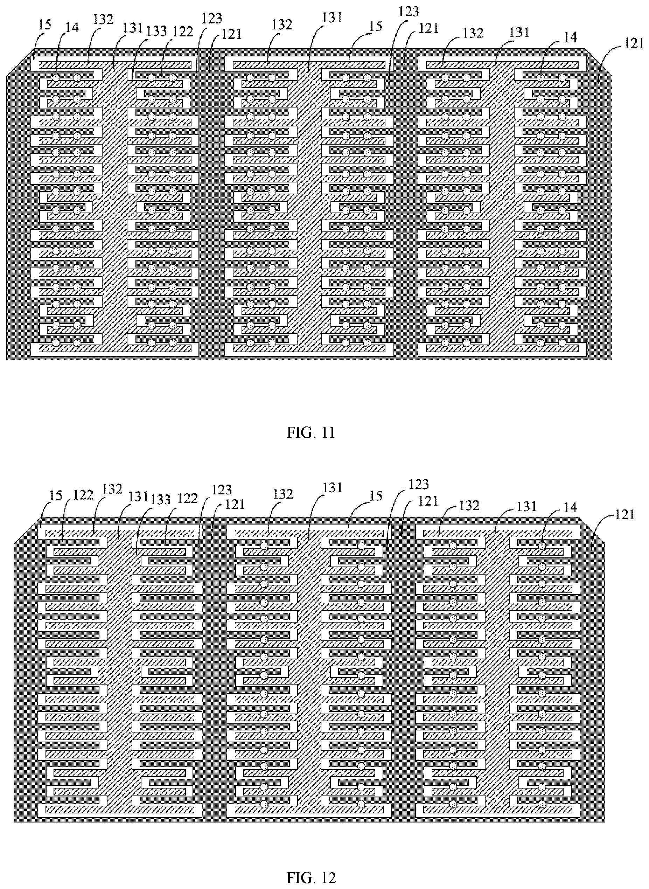

Referring to FIGS. 8 to 13, in some embodiments, a plurality of leakage conductive structures 14 are provided, and at least part of the leakage conductive structures 14 are connected to the first finger region 122 and the second finger region 132 that are adjacent to each other. As such, these leakage conductive structures 14 can provide leakage conduction to the region adjacent to the first finger region 122 and the second finger region 132, alleviating or preventing the adverse impact of the hot spot effect on the IBC photovoltaic module when the hot spot effect occurs.

It should be noted that, one or more of the leakage conductive structures 14 may be provided between one first finger region 122 and a second finger region 132 adjacent thereto. A plurality of the leakage conductive structures 14 can be spaced apart uniformly or non-uniformly in the longitudinal directions of the first finger region 122 and second finger region 132. The positions of the leakage conductive structures 14 on different first finger regions 122 or different second finger regions 132 may correspond or may not correspond.

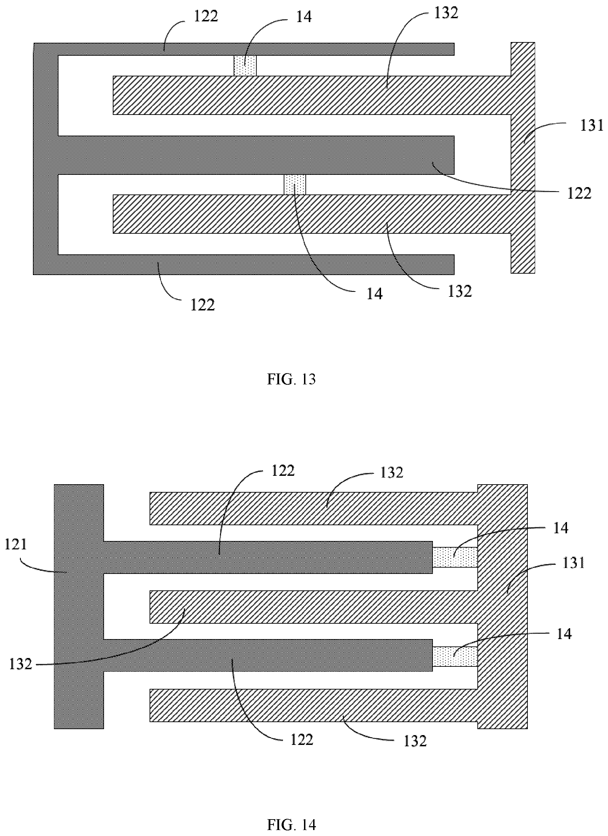

Referring to FIG. 14, in some embodiments, a plurality of leakage conductive structures 14 can be provided, and at least part of the leakage conductive structures 14 are connected between the first finger region 122 and the second busbar region 131. That is, the end of the first finger region 122 is connected to the second busbar region 131 through the leakage conductive structure 14. As such, leakage conduction can be performed on the region adjacent to the end of the first finger region 122 and the second finger region 132, thus alleviating or preventing the adverse impact of the hot spot effect on the IBC photovoltaic module when the hot spot effect occurs.

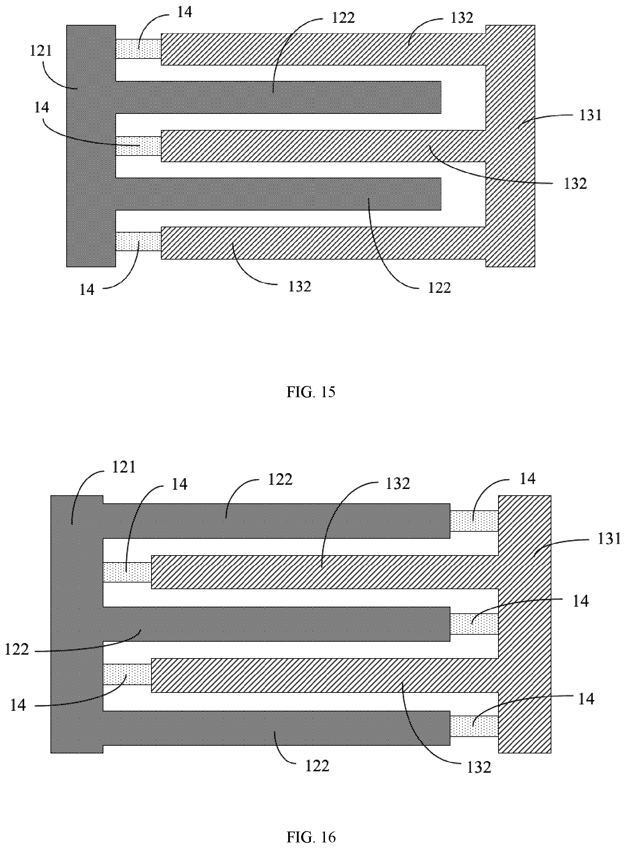

Referring to FIG. 15, similarly, in some embodiments, a plurality of leakage conductive structures 14 can be provided, and at least part of leakage conductive structures 14 are connected between the second finger region 132 and the first busbar region 121. That is, the end of the second finger region 132 is connected to the first busbar region 121 through the leakage conductive structure 14. As such, leakage conduction can be performed on the region adjacent to the end of the second finger region 132 and the first busbar region 121, thus alleviating or preventing the adverse impact of the hot spot effect on the IBC photovoltaic module when the hot spot effect occurs.

Referring to FIG. 16, in some embodiments, a plurality of leakage conductive structures 14 can be provided, a part of the leakage conductive structures 14 are connected between the first finger region 122 and the second busbar region 131, and other part of the leakage conductive structures 14 are connected between the second finger region 132 and the first busbar region 121. That is, the end of the first finger region 122 is connected to the second busbar region 131 through the leakage conductive structures 14, and the end of the second finger region 132 is connected to the first busbar region 121 through the leakage conductive structures 14.

In some embodiments, a plurality of leakage conductive structures 14 are provided. A plurality of first soldering pad regions 123 are provided on the first busbar region 121, and at least part of the leakage conductive structures 14 are connected between the second finger region 132 and the plurality of first soldering pad regions 123. That is, the end of the second finger region 132 is connected to the first soldering pad region 123 through the leakage conductive structure 14. As such, leakage conduction can be performed on the region adjacent to the end of the second finger region 132 and the first soldering pad region 123, thus alleviating or preventing the adverse impact of the hot spot effect on the IBC photovoltaic module when the hot spot effect occurs.

In some embodiments, a plurality of leakage conductive structures 14 can be provided. A plurality of second soldering pad regions 133 are provided on the second busbar region 131, and at least part of the leakage conductive structures 14 are connected between the first finger region 122 and the plurality of second soldering pad regions 133. That is, the end of the first finger region 122 is connected to the second soldering pad region 133 through the leakage conductive structure 14. As such, leakage conduction can be performed on the regions adjacent to the end of the first finger region 122 and the second soldering pad region 133, thus alleviating or preventing the adverse impact of the hot spot effect on the IBC photovoltaic module when the hot spot effect occurs.

Referring to FIG. 1, in some embodiments, a first passivation tunneling layer 16 is provided between the first doped layer 12 and the backside of the silicon substrate 11. A second passivation tunneling layer 17 is provided between the second doped layer 13 and the backside of the silicon substrate 11. Thus, the first doped layer 12 and its corresponding first passivation tunneling layer 16 cooperatively form a passivated contact structure, and the second doped layer 13 and its corresponding second passivation tunneling layer 17 cooperatively form a passivated contact structure.

In some embodiments, the second passivation tunneling layer 17 is integrally formed with the leakage tunneling layer 143. The first passivation tunneling layer 16 abuts against the leakage tunneling layer 143.

Referring to FIG. 1, in some embodiments, a passivating layer 18 and a protective layer 19 are sequentially stacked on the sides of the first doped layer 12, the second doped layer 13, the isolation region 15, and the leakage conductive structure 14 away from the silicon substrate 11. By providing the passivating layer 18 on the backside of the silicon substrate 11, the passivation effect can be further improved. By providing the protective layer 19, the silicon substrate 11 and doped layers can be protected from external damage, while also providing passivation and/or adjusting the light reflectivity. The passivating layer 18 can be made of conventional passivation materials such as aluminum oxide. The protective layer 19 can be made of conventional materials with certain passivation effect such as silicon nitride, and silicon oxynitride. It should be understood that, the passivating layer 18 and the protective layer 19 can also be provided on the front side of the silicon substrate 11, but the protective layer 19 on the front side needs to have an anti-reflection effect.

Referring to FIG. 1, in some embodiments, a first electrode 20 is provided on the first doped layer 12, and a second electrode 21 is provided on the second doped layer 13, thereby collecting and extracting carriers. The first electrode 20 extends through the protective layer 19 and the passivating layer 18 on the first doped layer 12 and is connected to the first doped layer 12. The second electrode 21 extends through the protective layer 19 and the passivating layer 18 on the second doped layer 13 and is connected to the second doped layer 13.

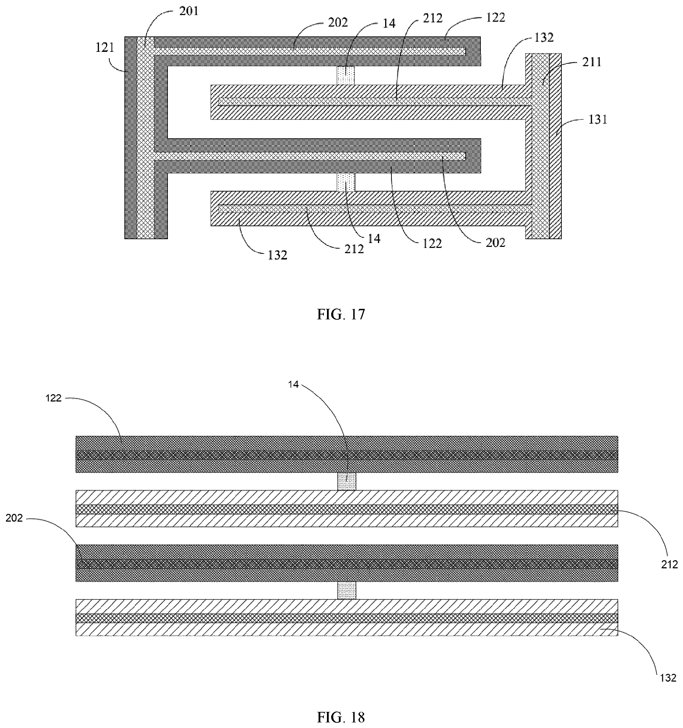

Referring to FIG. 17, specifically, the first electrode 20 includes a first busbar 201 and a first finger 202. The first busbar 201 is connected to the first busbar region 121. The first finger 202 is connected to the first finger region 122. The second electrode 21 includes a second busbar 211 and a second finger 212. The second busbar 211 is connected to the second busbar region 131. The second finger 212 is connected to the second finger region 132. The first finger 202 and the second finger 212 are configured to collect carriers from the silicon substrate 11 and transport them to the first busbar 201 and the second busbar 211, respectively. The first busbar 201 and the second busbar 211 are configured to extract the carriers.

In some embodiments, the IBC solar cell 10 is of a busbar-free structure. The leakage conductive structure 14 is located at any position between the first finger region 122 and the second finger region 132. Referring to FIG. 18, the first electrode includes the first fingers 202 connected to the first finger regions 122. The second electrode includes the second fingers 212 connected to the second finger region 132. The first finger 202 and the second finger 212 are configured to collect carriers from the silicon substrate 11.

An embodiment of the present application provides a method for preparing the above-described IBC solar cell 10, including the following steps:
providing a silicon substrate 11; and
forming a first doped layer 12, a first conductive block 141, a second doped layer 13, a second conductive block 142, and a leakage tunneling layer 143 on a backside of the silicon substrate 11, respectively;
wherein the first doped layer 12 and the second doped layer 13 are spaced apart to form an isolation region 15, a first conductive block 141 is located in the isolation region 15 and connected to the first doped layer 12; the second conductive block 142 is located in the isolation region 15 and connected to the second doped layer 13; the first conductive block 141 and the second conductive block 142 are partially overlapped, the leakage tunneling layer 143 is provided between the first conductive block 141 and the second conductive block 142, and the first conductive block 141, the second conductive block 142, and the leakage tunneling layer 143 constitute a leakage conductive structure 14.

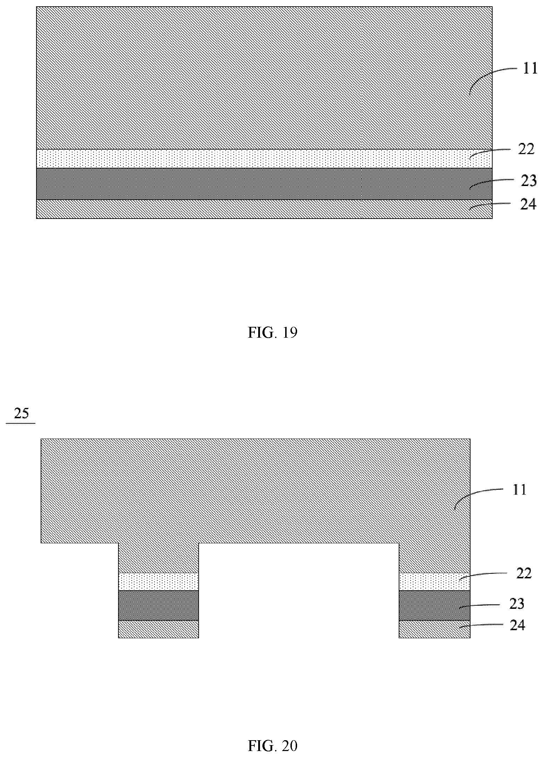

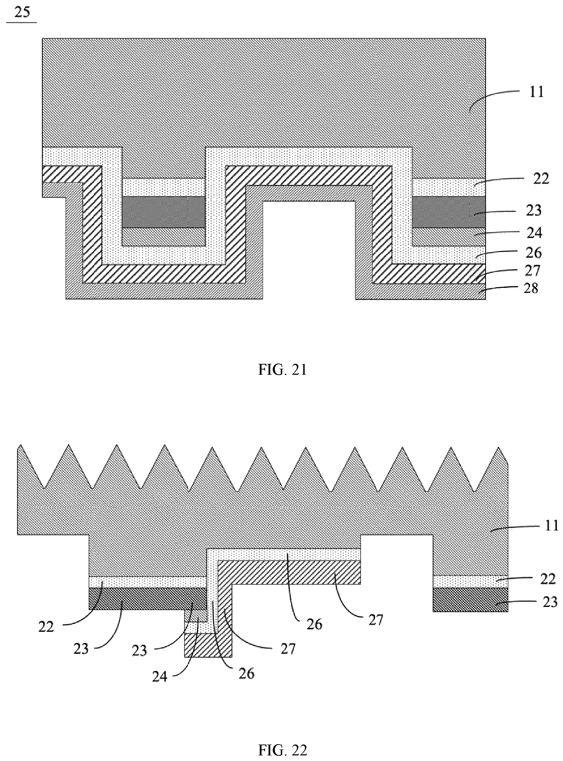

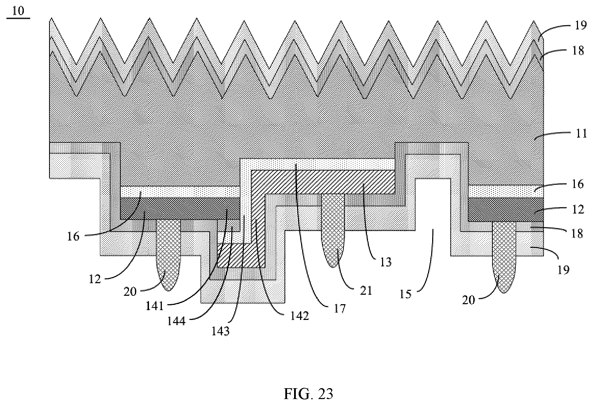

Referring to FIG. 19 to 23, in some embodiments, the first doped layer 12 and the first conductive block 141 are first formed on the backside of the silicon substrate 11. Then, the second doped layer 13, the second conductive block 142, and the leakage tunneling layer 143 are formed on the backside of the silicon substrate 11, and the second doped layer 13 is spaced apart from the first doped layer 12 to form the isolation region 15.

Thus, by first forming the first doped layer 12 and the first conductive block 141 are first formed on the backside of the silicon substrate 11, and then forming the second doped layer 13, the second conductive block 142, and the leakage tunneling layer 143 on the backside of the silicon substrate 11, the second doped layer 13 is spaced apart from the first doped layer 12 to form the isolation region 15. The first conductive block 141, the leakage tunneling layer 143, and the second conductive block 142 form the leakage conductive structure 14 within the isolation region 15, and the first conductive block 141 and the second conductive block 142 are partially overlapped. This preparation method has lower precision requirements for the process when forming the leakage conductive structure 14, is less affected by manufacturing precision and process fluctuations, and is easier to achieve in the process, making it more feasible for production.

In some embodiments, a first tunneling oxide layer 22, a first doped silicon layer 23, and a first mask layer 24 are sequentially deposited on the backside of the silicon substrate 11. Then, portions of the first mask layer 24, the first doped silicon layer 23, and the first tunneling oxide layer 22 outside the regions of the first doped layer 12 and the first conductive block 141 on the backside of the silicon substrate 11 are removed, thereby forming the first doped layer 12 and the first conductive block 141 on the backside of the silicon substrate 11 to obtain a cell intermediate 25. As such, the first doped layer 12 and the first conductive block 141 can be formed simultaneously, resulting in an integrally formed structure of the first doped layer 12 and the first conductive block 141, which further simplifies the cell preparation process.

It should be understood that in the above preparation method, within the regions of the first doped layer 12 and the first conductive block 141 on the backside of the silicon substrate 11, the retained first doped silicon layer 23 serves as the first doped layer 12 and the first conductive block 141 in the subsequently prepared IBC solar cell 10, and the retained first tunneling oxide layer 22 serves as the first passivation tunneling layer 16 in the subsequently prepared IBC solar cell 10.

In some embodiments, a second tunneling oxide layer 26, a second doped silicon layer 27, and a second mask layer 28 are sequentially deposited on the backside of the silicon substrate 11 of the cell intermediate 25. Then, portions of the second mask layer 28, the second doped silicon layer 27, the second tunneling oxide layer 26, and the first mask layer 24 outside the regions of the second doped layer 13 and the second conductive block 142 on the backside of the silicon substrate 11 are removed, followed by removing the remaining second mask layer 28, so that the second doped layer 13, the second conductive block 142, and the leakage tunneling layer 143 on the backside of the silicon substrate 11 can be formed, and the isolation region 15 can be formed between the second doped layer 13 and the first doped layer 12. The retained first mask layer 24 serves as the insulating layer 144 in the subsequently prepared IBC solar cell 10. As such, the second doped layer 13 and the second conductive block 142 can be formed simultaneously, resulting in an integrally formed structure of the second doped layer 13 and the second conductive block 142, which further simplifies the cell preparation process.

It should be understood that in the above preparation method, within the regions of the second doped layer 13 and the second conductive block 142 on the backside of the silicon substrate 11, the retained second doped silicon layer 27 serves as the second doped layer 13 and the second conductive block 142 in the IBC solar cell 10, and the retained second tunneling oxide layer 26 serves as an integrally formed leakage tunneling layer 143 and the second passivation tunneling layer 17 in the IBC solar cell 10.

In some embodiments, the first doped silicon layer 23 is a boron-doped silicon layer, the first mask layer 24 is a borosilicate glass layer, the second doped silicon layer 27 is a phosphorus-doped silicon layer, and the second mask layer 28 is a phosphosilicate glass layer. In some other embodiments, the first doped silicon layer 23 is a phosphorus-doped silicon layer, the first mask layer 24 is a phosphosilicate glass layer, the second doped silicon layer 27 is a boron-doped silicon layer, and the second mask layer 28 is a borosilicate glass layer. Bothe the first tunneling oxide layer 22 and the second tunneling oxide layer 26 can be an ultra-thin silicon oxide layer with a thickness of 5 nm or less. Further, the thickness can be in a range from 1 nm to 3 nm.

In some embodiments, the first mask layer 24, the first doped silicon layer 23, and the first tunneling oxide layer 22 outside the regions of the first doped layer 12 and the first conductive block 141 on the backside of the silicon substrate 11 are removed by the following method: First, the first mask layer 24 outside the regions of the first doped layer 12 and the first conductive block 141 on the backside of the silicon substrate 11 is etched with a laser. Then, the first doped silicon layer 23 and the first tunneling oxide layer 22 outside the regions of the first doped layer 12 and the first conductive block 141 on the backside of the silicon substrate 11 are etched away by using an alkaline solution.

Specifically, the first mask layer 24 outside the regions of the first doped layer 12 and the first conductive block 141 on the backside of the silicon substrate 11 is etched with a nanosecond, picosecond, or femtosecond laser with a spot size of 10 µm to 300 µm, a wavelength of 200 nm to 1300 nm, and an energy density of 100 mJ/cm² to 600 mJ/cm². Then, the first doped silicon layer 23 and the first tunneling oxide layer 22 outside the regions of the first doped layer 12 and the first conductive block 141 on the backside of the silicon substrate 11 are etched at 50°C to 90°C for 1 min to 30 min for removing them by using a sodium hydroxide solution with a concentration of 0.5 wt% to 30 wt%.

In some embodiments, the second doped silicon layer 27 and the second tunneling oxide layer 26 outside the regions of the second doped layer 13 and the second conductive block 142 on the backside of the silicon substrate 11 are removed by the following method: The second doped silicon layer 27 and the second tunneling oxide layer 26 outside the regions of the second doped layer 13 and the second conductive block 142 on the backside of the silicon substrate 11 are etched away by using an alkaline solution. Similarly, the alkaline solution can be a sodium hydroxide solution with a concentration of 0.5 wt% to 30 wt%, the etching temperature for sodium hydroxide solution can be in a range from 50°C to 90 °C, and the etching time period can be in a range from 1 minutes to 30 minutes.

In some embodiments, after removing the second doped silicon layer 27 and the second tunneling oxide layer 26 outside the regions of the second doped layer 13 and the second conductive block 142 on the backside of the silicon substrate 11, a passivating layer 18 and a protective layer 19 are sequentially formed on both the front and back sides of the silicon substrate 11. Additionally, pastes for a first electrode 20 and a second electrode 21 are printed on the first doped layer 12 and the second doped layer 13 on the backside of the silicon substrate11, respectively, and then sintered to form the first electrode 20 and the second electrode 21. Further, the prepared IBC solar cell 10 can undergo light injection treatment.

An embodiment of the present application provides an IBC photovoltaic module (not shown). The IBC photovoltaic module includes a plurality of IBC solar cells 10 as described above, and the plurality of IBC solar cells 10 are interconnected to form an IBC solar cell string. By adopting the IBC solar cell 10 of the present application, the IBC photovoltaic module can effectively alleviate or prevent the concentration of leakage current in some local regions of the cell, thereby reducing the risk of hot spots in the IBC photovoltaic module.

An embodiment of the present application further provides a power generation device (not shown). The power generation device includes the IBC solar cell 10 or the IBC photovoltaic module of the present application. It should be understood that the power generation device includes various equipment incorporating the IBC solar cell 10 or IBC photovoltaic module of the present application, such as solar power plants, solar water heaters, solar street lights, solar drones, etc.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

## Claims

1. An IBC solar cell, comprising:
a silicon substrate;
a first doped layer and a second doped layer spaced apart on a backside of the silicon substrate, wherein doping types of the first doped layer and the second doped layer are different, and an isolation region is provided between the first doped layer and the second doped layer; and
a leakage conductive structure provided between the first doped layer and the second doped layer, wherein the leakage conductive structure comprises a first conductive block, a second conductive block, and a leakage tunneling layer, the first conductive block is connected to the first doped layer, and the second conductive block is connected to the second doped layer, the first conductive block and the second conductive block are partially overlapped, and the leakage tunneling layer is provided between the first conductive block and the second conductive block.

2. The IBC solar cell according to claim 1, wherein a material of the first conductive block is a same as or different from a material of the first doped layer; or
a material of the second conductive block is a same as or different from a material of the second doped layer.

3. The IBC solar cell according to claim 1, wherein the first conductive block comprises doped silicon with a same doping type as a doping type of the first doped layer; and/or
the second conductive block comprises doped silicon with a same doping type as a doping type of the second doped layer.

4. The IBC solar cell according to any one of preceding claims, wherein the first conductive block is integrally formed with the first doped layer; and/or
the second conductive block is integrally formed with the second doped layer.

5. The IBC solar cell according to any one of preceding claims, wherein the leakage tunneling layer is a silicon oxide layer or a hydrogenated amorphous silicon layer; and/or
a thickness of the leakage tunneling layer is in a range from 1 nm to 5 nm.

6. The IBC solar cell according to any one of preceding claims, wherein a width of the first conductive block is in a range from 5 µm to 500 µm; and/or
a width of the second conductive block is in a range from 5 µm to 500 µm.

7. The IBC solar cell according to any one of preceding claims, wherein a width of an overlapped portion between the first conductive block and the second conductive block is in a range from 1 µm to 300 µm.

8. The IBC solar cell according to any one of preceding claims, wherein along a thickness direction of the silicon substrate, an orthographic projection of the first conductive block is within an orthographic projection of the second conductive block, or an orthographic projection of the first conductive block is partially overlapped with an orthographic projection of the second conductive block.

9. The IBC solar cell according to any one of preceding claims, wherein the leakage conductive structure further comprises an insulating layer provided between overlapped portions of the first conductive block and the second conductive block.

10. The IBC solar cell according to claim 9, wherein the insulating layer comprises a phosphosilicate glass layer, a borosilicate glass layer, a silicon nitride layer, a silicon oxide layer, or any combination thereof; and/or
a thickness of the insulating layer is in a range from 1 nm to 90 nm.

11. The IBC solar cell according to claim 9, wherein a part of the leakage tunneling layer is provided between the insulating layer and the second conductive block.

12. The IBC solar cell according to any one of preceding claims, wherein the first doped layer comprises a first busbar region and a plurality of first finger regions connected to the first busbar region, the second doped layer comprises a second busbar region and a plurality of second finger regions connected to the second busbar region, and the first finger regions and the second finger regions located between adjacent first busbar region and second busbar region are alternately spaced apart;
optionally, wherein a plurality of leakage conductive structures are provided, and at least part of the leakage conductive structures are connected to the first finger region and the second finger region that are adjacent to each other;
optionally, wherein a plurality of leakage conductive structures are provided, and at least part of the leakage conductive structures are connected to the first finger region and the second busbar region;
optionally, wherein a plurality of leakage conductive structures are provided, and at least part of leakage conductive structures are connected to the second finger region and the first busbar region;
optionally, wherein a plurality of leakage conductive structures are provided, a plurality of first soldering pad regions are provided on the first busbar region, and at least part of the leakage conductive structures are connected to the second finger region and the plurality of first soldering pad regions;
optionally, wherein a plurality of leakage conductive structures are provided, a plurality of second soldering pad regions are provided on the second busbar region, and at least part of the leakage conductive structures are connected to the first finger region and the plurality of second soldering pad regions.

13. The IBC solar cell according to any one of preceding claims, further comprising:
a first passivation tunneling layer provided between the first doped layer and the silicon substrate, and between the first conductive block and the silicon substrate; and
a second passivation tunneling layer provided between the second doped layer and the silicon substrate.

14. The IBC solar cell according to claim 13, wherein the second passivation tunneling layer is integrally formed with the leakage tunneling layer.

15. The IBC solar cell according to claim 13, wherein the first passivation tunneling layer abuts against the leakage tunneling layer.
